## Europäisches Patentamt

## European Patent Office

## Office européen des brevets

(19)

(11) Veröffentlichungsnummer : **0 021 140**
**B1**

(12)

# EUROPÄISCHE PATENTSCHRIFT

(45) Veröffentlichungstag der Patentschrift :
24.08.83

(21) Anmeldenummer : 80103077.6

(22) Anmeldetag : 03.06.80

(51) Int. Cl.³ : **H 01 J 27/00, H 01 L 21/302**

(54) Ionenquelle in einer Vakuumkammer und Verfahren zum Betrieb derselben.

(30) Priorität : 29.06.79 US 53491

(43) Veröffentlichungstag der Anmeldung :
07.01.81 Patentblatt 81/01

(45) Bekanntmachung des Hinweises auf die Patenterteilung : 24.08.83 Patentblatt 83/34

(84) Benannte Vertragsstaaten :
DE FR GB

(56) Entgegenhaltungen :
CH A 441 532
DE A 2 625 870
FR A 2 218 652
GB A 1 298 490
GB A 1 359 707
GB A 1 466 786
GB A 1 513 218
US A 3 156 090
US A 3 355 615
US A 3 660 715
US A 3 744 247

(73) Patentinhaber : International Business Machines Corporation
Old Orchard Road
Armonk, N.Y. 10504 (US)

(72) Erfinder : Harper, James McKell Edwin
507 Elizabeth Road
Yorktown Hgts, N.Y.10598 (US)
Erfinder : Kaufman, Harold Richard
401 Spinnaker Lane
Fort Collins Colorado 80525 (US)

(74) Vertreter : Rudack, Günter O., Dipl.-Ing.
c/o International Business Machines Corporation
Zurich Patent Operations Säumerstrasse 4
CH-8803 Rüschlikon (CH)

## Ionenquelle in einer Vakuumkammer und Verfahren zum Betrieb derselben

Die vorliegende Erfindung betrifft eine Ionenquelle in einer Vakuumkammer zum Erzeugen eines Ionenstrahls mit hoher Stromdichte und geringer Ionenenergie zwecks Durchführung von reaktiven Materialätzverfahren, sowie ein Verfahren zu deren Betrieb.

Das trockene Aetzen von halbleitenden und isolierenden Substanzen durch reaktive Ionen wird in der Halbleitertechnologie als Verbesserung gegenüber nassen, chemischen Aetzverfahren immer wichtiger. Beim trockenen Aetzverfahren können drei Effekte unterschieden werden :

1. Oberflächenzerstäubung durch Ionenbombardement ;

2. chemisches Aetzen durch mit dem Oberflächenmaterial chemisch reagierende Neutralteilchen und Ionen ; und

3. « Ionen-unterstütztes » Aetzen durch Ionenbombardement, jedoch bei Ionenenergien, bei denen die Oberflächenzerstäubung vernachlässigbar ist.

Drei Grundarten von Trockenätzverfahren, welche die obengenannten Effekte ausnützen, sind physikalisches Ionenätzen, Plasma-Aetzen und reaktives Ionenätzen. Das physikalische Ionenätzen ist fast ganz auf Oberflächenzerstäubung zurückzuführen. Dabei werden üblicherweise die Ionen durch eine Ionenquelle mit Doppelgitterstruktur beschleunigt.

Beim Plasma-Aetzen werden die zu bearbeitenden Plättchen in eine Kammer mit reaktivem Gas (z. B. $CF_4$) bei einem Druck von etwa 133 Pa (1 Torr) gebracht. Eine Glimmentladung (Plasma) wird durch eine ausserhalb der Kammer angebrachte und durch Hochfrequenz erregte Induktionsspule ausgelöst. Im Plasma werden durch Ionisation und Dissoziation reaktive Teilchen gebildet. Sie diffundieren zu den Plättchenoberflächen, die annähernd auf demselben Potential wie das Plasma gehalten werden. Der Beschuss der Plättchen erfolgt aus allen Winkeln, was isotropes Aetzen hauptsächlich durch energetisch neutrale Gasatome bewirkt, wodurch chemisches Trockenätzen überwiegt.

Reaktives Ionenätzen eröffnet die Möglichkeit des anisotropen Aetzens, das für die Ausgestaltung feinster Oberflächenstrukturen von höchster Wichtigkeit ist. Bei diesem Vorgang überwiegen chemisches und Ionen-unterstütztes Aetzen, aber es kann auch etwas Zerstäuben auftreten. Die Halbleiterplättchen werden auf die Kathode gelegt, welche für eine beim typischen Druck von 4 Pa (30 · $10^{-3}$ Torr) erfolgende Hochfrequenz-Entladung benutzt wird. Die Kathodenspannung liegt dabei zwischen 600 und 900 V Spitze-zu-Spitze. Oberhalb der Kathode bildet sich eine Ionenschicht, die einen Bereich zur Beschleunigung von positiven Ionen (z. B. $CF_{3+}$) in Richtung auf die Kathodenoberfläche darstellt. Diese Ionen treffen nahezu senkrecht auf die Oberfläche auf und bewirken dadurch ein gerichtetes bzw. anisotropes Aetzen. Der geringere Druck sorgt dabei für die Aufrechterhaltung der Vorzugsrichtung der reaktiven Ionen.

In einem Artikel von J. W. Coburn, H. F. Winters und T. J. Chung « Ion-Surface Interaction in Plasma Etching » im Journal of Applied Physics, Bd. 48, Nr. 8, Aug. 1977, S. 3532-3540, ist die Verwendung von Ionenstrahlen beim reaktiven Aetzen beschrieben. Dazu wird eine Ionenquelle mit nur einer Oeffnung verwendet, um verschiedene Substrate unterschiedlichen Materials mit Ionenstrahlen aus Substanzen wie $CF_{3+}$ und $Ar^+$ zu beschiessen. Die beschriebene Quelle mit nur einer Oeffnung ist auf Ströme im niederen μA-Bereich begrenzt. Auch kann diese Quelle nicht zum gleichmässigen Aetzen grosser Oberflächen verwendet werden.

Die Technologie der Ionenquellen ist für reaktive Ionen-Aetzverfahren von Interesse. Es sind während vieler Jahre Ionenquellen gebraucht worden, die mit Mehrfachgitter-Beschleunigungsanordnungen versehen waren. In der USA-Patentschrift Nr. 3,156,090 ist eine solche Anordnung beschrieben, die in ähnlicher Form seither oft für Ionenzerstäubung gebraucht worden ist. Etwas jünger ist der Artikel von D. Pigache « A Laboratory Simulation of the Ionenspheric Plasma » im AIAA Journal, Bd. 11, S. 129-130, Febr. 1973, der eine Ionenquelle für hohe Stromdichten beschreibt, welche dank einer Beschleunigungsvorrichtung mit einem einzigen Gitter Ionen mit geringer Energie liefert. Diese Ionenquelle ist für die Simulation der Ionensphäre eingesetzt worden, da sie ein Plasma hoher Dichte, aber geringer Energie erzeugen kann. Eine ähnliche Vorrichtung zur Gewinnung von Ionen ist in der USA-Patentschrift Nr. 3,660,715 dargelegt, bei welcher ein feines Maschengitter oder ein mosaikartiges Element verwendet wird.

In der USA-Patentschrift Nr. 3,355,615 ist eine Doppelgitter-Beschleunigungsvorrichtung gezeigt, bei der dem Gitterpaar noch ein feines Maschengitter hinzugefügt wird, um den Ort der sich bildenden Plasmaschicht zu bestimmen. Trotz des zusätzlichen Maschengitters handelt es sich im wesentlichen um eine Doppelgitter-Anordnung, wobei das Maschengitter zu einem der beiden Gitter gehört. Diese Vorrichtung ist nicht in der Lage, hohen Stromdichten von Ionen geringer Energie zu liefern, die durch die erwähnte Einrichtung von Pigache mit nur einem Gitter erzeugbar sind.

Eine weitere Art von Doppelgitter-Beschleunigungsvorrichtung ist in der USA-Patentschrift Nr. 3,744,247 gezeigt. Bei dieser wird zwischen einem Metallgitter und der Entladungskammer einer Ionenantriebsvorrichtung eine Schicht dielektrischen Materials eingefügt. Der Isolator erzeugt eine beschleunigende Spannungsdifferenz ähnlich jener, die in einer Doppelgittereinrichtung erzeugt wird.

Aus der DE-A1-2 625 870 bzw. GB-A-1 359 707 sind Ionenquellen in Ionenätzanlagen mit den im Oberbegriff des vorliegenden Anspruchs 1 genannten Merkmalen bekannt.

Die im Anspruch 1 definierte Erfindung hat die Aufgabe, eine Ionenquelle anzugeben, die zur Durchführung von reaktiven Materialätzverfahren bei möglichst geringer Oberflächenzerstäubung einen Ionenstrahl hoher Stromdichte und geringer Ionenenergie erzeugt. Gleichzeitig wird ein Verfahren zum Betrieb besagter Ionenquelle aufgezeigt, das die verlangte Wirkung zeigt.

Die vorliegende Erfindung ist nachstehend anhand eines Ausführungsbeispiels und zugehöriger Zeichnungen eingehend erläutert. Es zeigen :

Figur 1    eine Einrichtung zum Aetzen mittels reaktiven Ionenstrahls gemäss vorliegender Erfindung,

Figur 2    eine bekannte Einrichtung mit Doppelgitter zur Erzeugung von Ionenstrahlen und verwendbar für Schleifbehandlung,

Figur 3A    eine Plasmahülle, die sich am Beschleunigungsgitter der Einrichtung gemäss Fig. 1 bildet, und

Figur 3B    einen Abschnitt des mit vielen Oeffnungen versehenen Gitters der Einrichtung gemäss vorliegender Erfindung.

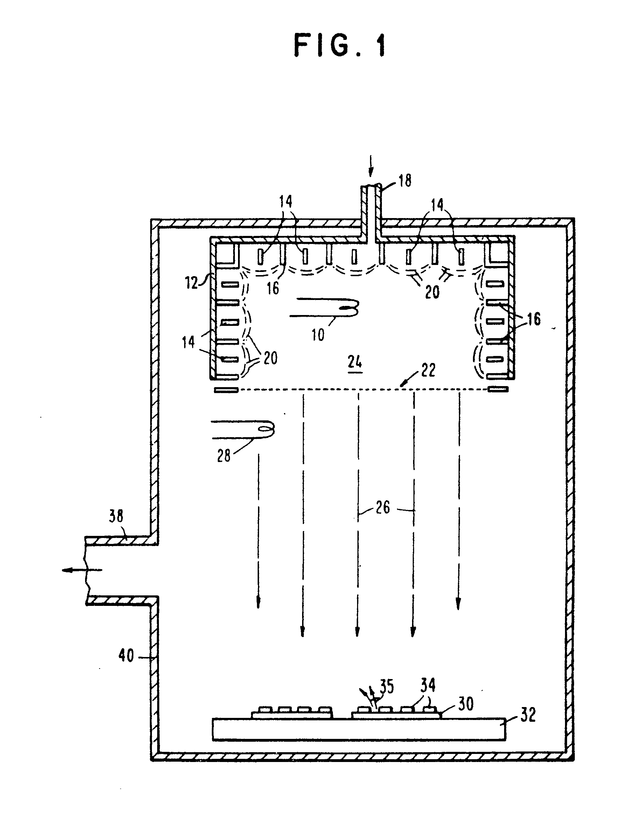

Die Fig. 1 zeigt eine erfindungsgemässe Einrichtung zum Aetzen mittels reaktiven Ionenstrahls. Eine Ionenquelle mit einem Gitter und Halbleiterplättchen auf Trägern sind zusammen in einer Vakuumkammer eingeschlossen. Die Ionenquelle umfasst eine Glühkathode 10, die sich in einer durch die Wandung 12 abgegrenzten kleineren Kammer befindet. Eine Anzahl Anoden 14 sind um die Glühkathode herum nahe der Wandung 12 angeordnet. Sie bestehen aus nichtmagnetischem Material, beispielsweise aus rostfreiem Stahl. Die Anoden 14 sind beidseitig von Polstücken 16 eingerahmt, die aus magnetisierbarem Material wie Weicheisen bestehen.

Für den Betrieb der Ionenquelle wird ein reaktives Gas wie $CF_4$ (Tetrafluor-Kohlenstoff) über einen Einlass 18 in die Ionenquelle eingebracht. Das Gas ionisiert unter dem Einfluss der von der Kathode 10 ausströmenden Elektronen, die in Richtung auf die Anoden 14 beschleunigt werden. Zwischen den Polstücken 16 werden magnetische Feldlinien 20 erzeugt, welche den Wirkungsgrad der Ionisation unterstützen. Am unteren Rand der Ionenquelle befindet sich ein Beschleunigungsgitter 22 mit vielen Oeffnungen, von dem Einzelheiten weiter unten beschrieben werden. In der Kammer der Ionenquelle bildet sich ein Plasma 24 aus Ionen und Elektronen, das die Quelle für den Ionenstrahl darstellt. Diese Ionen werden dem Plasma durch die Oeffnungen des Beschleunigungsgitters 22 hindurch entzogen und bilden einen Strahl, der durch die Linien 26 der Ionenflugbahnen bildlich dargestellt ist.

Dem Strahl 26 werden durch einen Neutralisator 28 Elektronen zugesetzt, um die Aufladung der isolierenden Halbleiterplättchen 30 zu verhindern. Diese letzteren werden zwecks Erzeugung von Aetzmustern durch den energiemässig schwachen Ionenstrahl 26 beschossen. Die Halbleiterplättchen 30 sind auf einem Träger 32 befestigt. Sie tragen Maskenmaterial 34, welches die gewünschten Aetzmuster begrenzt.

Reaktive Bestandteile des Ionenstrahls 26 verbinden sich mit Atomen der Halbleiterplättchen 30 und bilden Aetzprodukte die mit der Ziffer 35 bezeichnet sind. Solche Aetzprodukte bestehen oft aus flüchtigen Gasen, die anschliessend über eine Oeffnung 38 aus der Kammer 40 abgesaugt werden. Das Maskenmaterial 34 wird derart ausgewählt, dass es mit dem Ionenstrahl 26 nur schwer eine Verbindung eingeht. Dadurch bleibt die Maske beständig, während das Halbleiterplättchen mit dem Aetzmuster versehen wird.

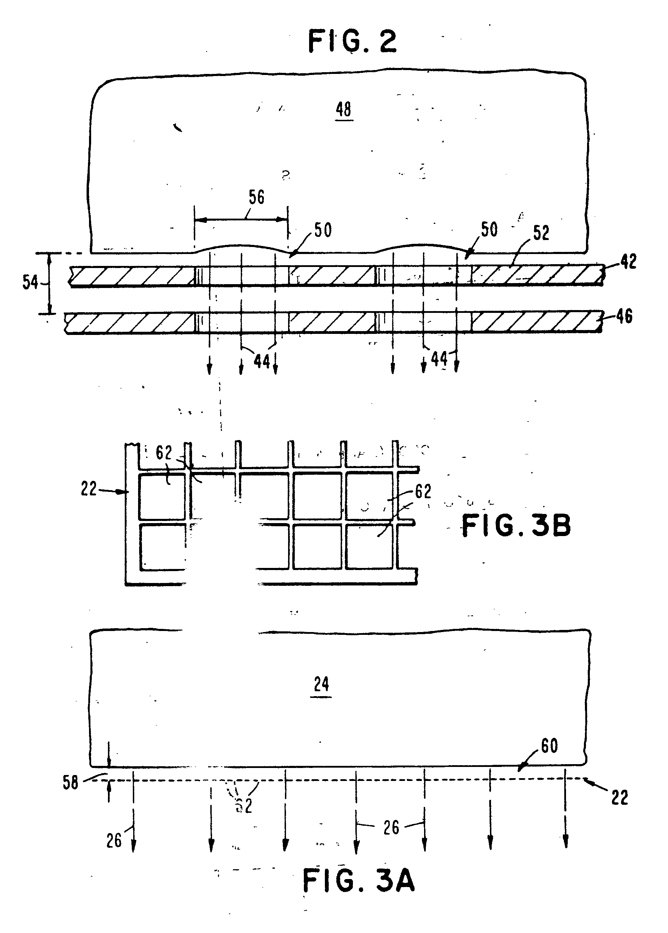

In der Fig. 2 ist eine Einrichtung mit zwei Gittern der bekannten Art zur Oberflächenzerstäubung mittels Ionen abgebildet, bei der ein Schirmgitter 42 auf ein positives Potential gebracht ist, das nahe bei jenem des Plasmas in der Kammer liegt. Einzelheiten, die in Fig. 2 nicht gezeigt sind, entsprechen jenen der Fig. 1. Das Schirmgitter 42 dient dazu, den Ionenfluss in mehrere, definierte Strahlenbündel 44 zu teilen, die im Normalbetrieb ein Beschleunigungsgitter 46 durchsetzen. Das Plasma ist in Fig. 2 mit der Ziffer 48 bezeichnet und jede Gitteröffnung mit 50. Eine Plasmaschicht bildet sich bei 52 in der Nähe des Schirmgitters 42. Die Beschleunigungsstrecke der Ionen ist mit 54 bezeichnet und entspricht dem Abstand zwischen dem Beschleunigungsgitter 46 und dem Plasma 48 jenseits des Schirmgitters 42. In diesem Fall ist die Ionendichte im Ionenstrahl durch die Beschleunigungsstrecke 54 begrenzt, die wegen des Vorhandenseins des Schirmgitters 42 nicht kleiner als etwa 1-2 mm gemacht werden kann.

Das Beschleunigungsgitter 46 ist gegenüber der Neutralisatorkathode, die nicht abgebildet ist, negativ vorgespannt, um den Rückfluss neutralisierender Elektronen zu verhindern. Wenn die einzelnen Ionenstrahlen 44 durch die Oeffnungen 50 die Beschleunigungseinrichtung verlassen, verschmelzen sie in grösserem Abstand zu den Oeffnungen zu einem breiten Ionenstrahl, der nicht mehr abgebildet ist. Die Oeffnungen 50 haben eine Weite, die mit der Ziffer 56 bezeichnet ist.

Die Stromergiebigkeit einer Doppelgitter-Beschleunigungseinrichtung ergibt sich angenähert aus der Formel nach Child :

$$j = (4\varepsilon_0/9) \cdot (2q/m)^{1/2} V^{3/2}/ \ell^2$$

worin (in SI- oder mks-Einheiten) j die Stromdichte ist, $\varepsilon_0$ die Dielektrizitätskonstante des freien Raumes, q/m das Ladung-zu-Masse-Verhältnis der Ionen, V ist die Spannung zwischen den Gittern und $\ell$ die Beschleunigungsstrecke 54 von Fig. 2. Die Formel von Child zeigt klar, dass für hohe Ionenstromdichte

bei kleinen Spannungen sehr kleine Gitterabstände in einer Doppelgitter-Beschleunigungseinrichtung notwendig sind. Daraus ergeben sich besondere Probleme im Fall eines grossen Ionenstrahldurchmessers, da dann über einen grossen Strahlquerschnitt ein kleiner Gitterabstand beibehalten werden muss. Bei bekannten Doppelgittereinrichtungen ist die maximal erzielbare Stromdichte etwa 2-3 mA/cm² für Argonionen von 500 eV und einem Strahldurchmesser bis zu 10 cm. Wird die Energie der Argonionen auf 100 eV herabgesetzt, dann sinkt die Stromdichte um mehr als den Faktor zehn.

Zur Verbesserung der Fokussierung werden oft zusätzliche Gitter verwendet. Ein weiteres Gitter ist zwischen dem Schirm- und dem Beschleunigungsgitter eingesetzt worden, wie auch ein Gitter, das mit der Vakuumkammer und der Neutralisatorkathode zusammen geerdet und auf der Neutralisatorseite des Beschleunigungsgitters angeordnet worden ist. Diese zusätzlichen Gitter können aber die Forderung nach geringem Gitterabstand für hohe Stromdichten nicht mildern.

In der Fig. 3A ist die Einrichtung mit nur einem Gitter zur reaktiven Aetzung mittels Ionenstrahls gemäss Fig. 1 abgebildet. Das Plasma 24, das Beschleunigungsgitter 22 und die Flugbahnen 26 der Ionen des Ionenstrahls sind schematisch dargestellt und mit denselben Ziffern bezeichnet wie in Fig. 1. In dieser Einrichtung mit nur einem Gitter, bei der die Ionen direkt aus dem Plasma 24 der Kammer heraus beschleunigt werden, bildet sich eine Plasmaschicht 60 zwischen dem eigentlichen Plasma und dem Beschleunigungsgitter 22. Die Beschleunigungsstrecke ist mit der Ziffer 58 bezeichnet und entspricht der Dicke der Plasmaschicht in der Nähe des Beschleunigungsgitters 22. Diese Beschleunigungsstrecke 58 oder Dicke der Schicht 60 nimmt mit der Beschleunigungsspannung, nämlich der Potentialdifferenz zwischen dem Plasma 24 und dem Gitter 22, zu. Bei geringen Beschleunigungsspannungen kann sich diese Strecke der Deybe-Länge der Ionen im Plasma nähern, die etwa 0,1 mm ist.

Bei geringer Ionenenergie erzeugt daher die Einrichtung mit nur einem Gitter gemäss den Fig. 1 und 3 eine grössere Ionenstromdichte als die Doppelgittereinrichtung, wie dies aus der Formel von Child hervorgeht. Gemäss dieser Formel ist die Stromdichte der Beschleunigungsstrecke im Quadrat umgekehrt proportional. Die Beschleunigungsstrecke 58 in der Eingittervorrichtung von Fig. 3 entspricht der Ionenschichtdicke, die in der Grössenordnung von 0,1 mm liegt. Die Beschleunigungsstrecke 54 in der üblichen Doppelgittervorrichtung von Fig. 2 liegt jedoch bei 1-2 mm, weil das Vorhandensein eines Schirmgitters 42 der Beschleunigungsstrecke eine untere Grenze setzt. Bei Anwendung der Formel von Child auf die Eingittervorrichtung ist V die Potentialdifferenz zwischen dem Plasma 24 und dem Beschleunigungsgitter 22 und $\ell$ ist die Beschleunigungsstrecke 58. So wird auch klar, dass bei geringer Ionenenergie die Eingittervorrichtung eine grössere Ionenstromdichte erzeugt als die Doppelgittereinrichtung.

Die Fig. 3B zeigt einen Ausschnitt des Beschleunigungsgitters 22 von Fig. 3A. Hier ist zu beachten, dass in Wirklichkeit die Beschleunigungsstrecke 58 grösser ist als die Grösse der Oeffnung 62 des Gitters 22. Die rechteckigen Oeffnungen 62, die in der Ausführung von Fig. 3B abgebildet sind, entsprechen einer typischen Form, es können aber auch andere Formen verwendet werden. Jedenfalls müssen bei den mit dieser Einrichtung benutzten Beschleunigungsgittern die Masse der Oeffnungen 62 etwa der Dicke der Plasmaschicht 60 bzw. der Beschleunigungsstrecke 58 entsprechen oder kleiner sein.

Es wurde eine Eingitter-Ionenquelle gebaut, um die Fähigkeit zum Aetzen von Halbleitermaterial mit Ionen aus reaktivem und inertem Gas zu prüfen. Dazu wurde ein Nickel-Maschengitter mit einem Oeffnungsmass von 75 µm und einer Drahtdicke von 10 µm verwendet. Der Ionenstrahldurchmesser betrug etwa 2,5 cm. Als Gas wurde entweder Argon oder CF₄ (Tetrafluor-Kohlenstoff) eingesetzt und Stromdichten des Ionenstrahls von 1 mA/cm² in einem Energiebereich von 20 bis 100 eV erzielt.

In einem Versuch sind Plättchen aus Si und SiO₂ einem Ionenstrahl aus Ar oder CF₄ mit 100 eV Energie ausgesetzt und die Aetzgeschwindigkeit gemessen worden. Um Ionen mit der Energie von 100 eV zu erhalten, sind die Anoden 14 auf eine positive Spannung von 100 V über Erdpotential gebracht worden. Das Beschleunigungsgitter wurde auf eine negative Spannung von − 40 V gegen Erde gesetzt. Eine Entladungsspannung von 40 V wurde zwischen der Kathode 10 und den Anoden 14 aufrechterhalten, um einen Entladungsstrom von 0,1 A fliessen zu lassen. Gleichzeitig floss ein Heizstrom von 4 A durch den Heizdraht der Neutralisatorkathode 16 um durch einen Elektronenstrom zu den Substratplättchen deren positive Aufladung durch den Ionenstrahl auszugleichen. Der Gasdruck in der Kammer 40 wurde auf $2,6 \cdot 10^{-2}$ Pa ($2 \cdot 10^{-4}$ Torr) gehalten.

Die Plättchen waren auf einem drehbaren, wassergekühlten Träger im Abstand von 14 cm von der Ionenquelle entfernt gelagert. Durch eine Maske wurden in der Plättchenoberfläche Stufen geätzt und anschliessend ausgemessen. Nachstehend die Resultate:

mit CF₄-Gas

| | |
|---|---|
| in SiO₂ Aetzgeschwindigkeit | 4 nm/min. |
| in Si | 1 nm/min. |

mit Ar-Gas

| | |
|---|---|
| in SiO₂ Aetzgeschwindigkeit | < 10 pm/min. |
| in Si | < 10 pm/min. |

Mit Argon erfolgt nur Ionenzerstäubung. Die Aetzgeschwindigkeiten sind wegen der geringen Ionenenergie sehr klein.

Mit $CF_4$-Gas erfolgt chemisches und Ionen-unterstütztes Aetzen von $SiO_2$ und Si, wobei flüchtige Produkte wie $SiF_4$, CO, $CO_2$ entstehen. Die erzielten Aetzgeschwindigkeiten zeigen, dass der von einer Eingitter-Ionenquelle stammende Ionenstrahl mit hoher Stromdichte und geringer Energie sich für reaktives Ionenätzen eignet. Die unterschiedlichen Aetzgeschwindigkeiten für verschiedene Materialien (z. B. $SiO_2$ gegenüber Si) sind für solche Anwendungen wichtig. Die Messungen haben ein Verhältnis von 4 : 1 zwischen der Aetzgeschwindigkeit von $SiO_2$ und jener von Si ergeben. Dieses Verhältnis kann durch Aenderungen in der Zusammensetzung des Aetzgases und der Ionenenergie beeinflusst werden.

Die Vorteile einer Eingitter-Ionenquelle mit vielen Oeffnungen für das reaktive Ionenätzen sind folgende :

1. Hohe Ionenstromdichte im Strahl (mehrere $mA/cm^2$), wobei die Stromdichte leicht und unabhängig von anderen Parametern eingestellt werden kann.

2. Geringe Energie der Ionen im Strahl (10-100 eV) zwecks Herabsetzung der Oberflächenzerstäubung auf ein Mindestmass. Die Ionenenergie ist definiert, und die Energieverteilung der Ionen am Ende des Ionenstrahls ist schmal, in der Grössenordnung von wenigen eV. Die geringe Ionenenergie schränkt die Beschädigung der Plättchen durch Ionen auf ein Minimum ein.

3. Der gerichtete Ionenstrahl kann aus verschiedenen Winkeln auf ein Substrat gerichtet werden, wodurch entweder vertikale Wände oder andere Wandprofile erzeugt werden können.

4. Die Dicke der Plasmaschicht und damit die Beschleunigungsstrecke stellen sich automatisch auf richtigen Abstand zum Beschleunigungsgitter ein. Daher kann der Durchmesser des Ionenstrahls viele Zentimeter betragen, um grosse Flächen bearbeiten zu können. Im Gegensatz dazu muss in einer Doppelgittervorrichtung der Gitterabstand mechanisch auf einem vorgegebenen Wert gehalten werden, damit die Beschleunigungsstrecke konstant bleibt. Die Eingitter Ionenquelle ist deshalb nicht nur als Forschungswerkzeug brauchbar, sondern kann bis zu einer für die Produktion brauchbaren Grösse erweitert werden.

Die vorliegende Erfindung hat also eine Einrichtung mit einem einzelnen Beschleunigungsgitter aufgezeigt, womit ein Ionenstrahl grosser Stromdichte und geringer Ionenenergie zur Verwendung beim reaktiven Ionenätzen erzeugt werden kann. Die grosse Ionenstromdichte ist auch bei grossem Strahldurchmesser erzielbar, weil die Beschleunigungsstrecke von der Dicke einer Plasmaschicht und nicht vom festen Abstand zweier Gitter bestimmt ist.

## Ansprüche

1. Ionenquelle in einer Vakuumkammer (40) zur Erzeugung eines Ionenstrahls hoher Stromdichte und geringer Ionenenergie zwecks Durchführung von reaktiven Materialätzverfahren in der Vakuumkammer, mit einer durch eine Wandung begrenzten Plasmakammer zur Aufnahme einer gasförmigen Substanz, deren Ionen mit dem zu ätzenden Material chemisch reagieren, und mit Mitteln (10, 14, 16) in der Plasmakammer zum Erzeugen eines Elektronenbombardementes der gasförmigen Substanz, um diese in ein Plasma (24) zu verwandeln, gekennzeichnet durch ein einziges, an den Plasmaraum direkt angrenzendes Beschleunigungsgitter (22) mit vielen Oeffnungen (62), um dem Plasma (24) Ionen zu entziehen und den Ionenstrahl (26) auf des zu ätzende Material zu richten.

2. Ionenquelle nach Anspruch 1, dadurch gekennzeichnet, dass die Grösse der Gitteröffnungen (62) gleich oder kleiner ist als die Dicke der sich am Gitter (22) bildenden Plasmaschicht (60).

3. Ionenquelle nach Anspruch 1, dadurch gekennzeichnet, dass die Grösse der Gitteröffnungen (62) annähernd 75 μm ist.

4. Ionenquelle nach Anspruch 1, dadurch gekennzeichnet, dass die Breite des festen Gittermaterials zwischen den Oeffnungen (62) etwa 10 μm beträgt.

5. Ionenquelle nach Anspruch 1, dadurch gekennzeichnet, dass die Mittel zum Erzeugen einer Gasentladung Anoden (14), wenigstens eine Glühkathode (10) und magnetisierbare Polstücke (16) zum Erzeugen von Magnetfeldern (20) umfassen, welche Polstücke entlang der Wandung (12) der Plasmakammer angeordnet sind, und dass das genannte Beschleunigungsgitter (22) eine Wand der Plasmakammer bildet.

6. Verfahren zum Betrieb einer Ionenquelle nach Anspruch 5, dadurch gekennzeichnet, dass die genannten Anoden (14) auf ein Potential von + 100 V gegenüber Erdpotential, die Kathode (10) gegenüber den Anoden auf ein Potential von − 40 V und das genannte Gitter (22) gegenüber Erdpotential auf ein Potential von − 40 V gelegt wird, und dass ferner in der Entladungskammer ein Gasdruck von $2,6 \cdot 10^{-2}$ Pa aufrechterhalten wird.

7. Verfahren nach Anspruch 6, dadurch gekennzeichnet, dass dem Plasma $CF_{3^+}$ Ionen entzogen werden und dass das zu ätzende Material Silizium enthält.

## Claims

1. Ion source in a vacuum chamber (40) for generating an ion beam of high current density and low ion energy for performing reactive etching of materials in the vacuum chamber, with a plasma discharge chamber, delimited by walls, for receiving a gaseous substance the ions of which will react chemically with the material to be etched, and with means (10, 14, 16) within the plasma discharge chamber for generating an electron bombardment of the gaseous substance in order to convert the same to a plasma (24), characterized by an acceleration grid (22) directly adjacent the plasma discharge chamber and having a plurality of apertures (62) for extracting ions from the plasma (24) and for directing the ion beam (26) onto the material to be etched.

2. Ion source according to claim 1, characterized in that the size of the apertures (62) in the grid is equal to or smaller than the thickness of the plasma sheath (60) forming at the grid (22).

3. Ion source according to claim 1, characterized in that the size of the apertures (62) in the grid is approximately 75 $\mu$m.

4. Ion source according to claim 1, characterized in that the width of the solid grid material between the apertures (62) is about 10 $\mu$m.

5. Ion source according to claim 1, characterized in that the means for generating a gas discharge comprise anodes (14), at least one thermionic cathode (10) and magnetizable pole pieces (16) for generating magnetic fields (20), the pole pieces being arranged along the wall (12) of the plasma discharge chamber, and that said acceleration grid (22) forms one wall of the plasma discharge chamber.

6. Method for operating an ion source according to claim 5, characterized in that said anodes (14) are maintained at a potential of $+ 100$ volts with respect to ground potential, the cathode (10) is maintained at a potential of $- 40$ volts with respect to the anodes, and the entire grid (22) is maintained at a potential of $- 40$ volts with respect to ground potential, and further that a gas pressure of $2,6 \cdot 10^{-2}$ Pa is maintained in the plasma discharge chamber.

7. Method according to claim 6, characterized in that $CF_{3^+}$ ions are extracted from the plasma, and that the material to be etched contains silicon.

### Revendications

1. Source d'ions dans une chambre à vide (40), en vue de produire un faisceau d'ions de haute densité de courant et de faible énergie d'ions, dans le but d'exécuter des opérations de décapage réactif de matériau dans une chambre à vide ; comportant une chambre à plasma, limitée par une cloison et destinée à recevoir une substance gazeuse dont les ions réagissent chimiquement avec le matériau à décaper, et comportant également des moyens (10, 14, 16) placés dans la chambre à plasma en vue de produire un bombardement électronique de la substance gazeuse afin de transformer celle-ci en un plasma (24) ; caractérisé par une grille d'accélération (22) unique, directement adjacente à la chambre à plasma et comportant de nombreuses ouvertures (62) visant à extraire des ions du plasma (24) et à diriger le faisceau d'ions (26) vers le matériau à décaper.

2. Source d'ions selon la revendication 1, caractérisé par le fait que la taille des ouvertures de la grille (62) est égale ou inférieure à l'épaisseur de la couche de plasma (60) se formant sur la grille (22).

3. Source d'ions selon la revendication 1, caractérisée par le fait que la taille des ouvertures de grille (62) est d'environ 75 $\mu$m.

4. Source d'ions selon la revendication 1, caractérisée par le fait que la largeur du matériau de grille solide entre les ouvertures (62) est d'environ 10 $\mu$m.

5. Source d'ions selon la revendication 1, caractérisée par le fait que les moyens servant à produire une décharge gazeuse comprennent des anodes (14), au moins une cathode à incandescence (10) et des pièces polaires magnétisables (16) visant à produire des champs magnétiques (20), lesquelles pièces polaires sont disposées le long de la cloison (12) de la chambre à plasma ; et que la grille d'accélération précitée (22) forme une paroi de la chambre à plasma.

6. Procédé pour faire fonctionner une source d'ions selon la revendication 5, caractérisé par le fait que les anodes précitées (14) sont mises à un potentiel de $+ 100$ V vis-à-vis du potentiel de terre ; que la cathode (10) est mise à un potentiel de $- 40$ V vis-à-vis des anodes ; que la grille précitée (22) est mise à un potentiel de $- 40$ V vis-à-vis du potentiel de terre ; et que, de plus, une pression gazeuse de $2,6 \cdot 10^{-2}$ Pa est maintenue dans la chambre à décharge.

7. Procédé selon la revendication 6, caractérisé par le fait que des ions $CF_{3^+}$ sont extraits du plasma, et que le matériau à décaper contient du silicium.

# FIG. 1

# FIG. 2

# FIG. 3B

# FIG. 3A